# FASCICULE DE BREVET EUROPEEN

(11) **EP 3 035 378 B1**
(45) Date de publication et mention de la délivrance du brevet: **26.07.2017**
(21) Numéro de dépôt: 15199956.2
(22) Date de dépôt: 14.12.2015
(51) Int. Cl.: H01L 21/683, H01L 23/485

(54) **PROCÉDÉ DE TRANSFORMATION D'UN DISPOSITIF ÉLECTRONIQUE UTILISABLE DANS UN PROCÉDÉ DE COLLAGE TEMPORAIRE D'UNE PLAQUE SUR UNE POIGNÉE ET DISPOSITIF ÉLECTRONIQUE FABRIQUÉ PAR LE PROCÉDÉ**
UMWANDLUNGSVERFAHREN EINER ELEKTRONISCHEN VORRICHTUNG VERWENDBAR IN EINEM VERFAHREN DES TEMPORÄREN BONDENS EINES WAFERS AUF EIN TRÄGERSUBSTRAT UND ELEKTRONISCHE VORRICHTUNG HERGESTELLT DURCH DAS VERFAHREN
METHOD FOR TRANSFORMING AN ELECTRONIC DEVICE USABLE IN A METHOD OF TEMPORARILY ADHERING A WAFER ON A SUPPORT AND ELECTRONIC DEVICE MANUFACTURED BY SAID METHOD

(30) Priorité: 19.12.2014 FR 1462978
(43) Date de publication de la demande: 22.06.2016
(73) Titulaire: COMMISSARIAT À L'ÉNERGIE ATOMIQUE ET AUX ÉNERGIES ALTERNATIVES, 75015 Paris (FR)
(72) Inventeur: PELLAT, Michel, 38000 GRENOBLE (FR); FOURNEL, Frank, 38190 VILLARD-BONNOT (FR); MONTMEAT, Pierre, 38190 FROGES (FR)
(74) Mandataire: Decobert, Jean-Pascal

(56) Documents cités:
- JP-A- 2014 133 855
- US-A- 4 794 092
- US-A1- 2011 006 400
- US-A1- 2014 110 894

## Description

### DOMAINE DE L'INVENTION

La présente invention est relative à l'intégration tridimensionnelle 3D pour des dispositifs électroniques et en particulier les dispositifs microélectroniques, le terme microélectronique incluant les nanotechnologies. L'invention concerne plus particulièrement la réalisation de dispositifs électroniques devant être manipulés avec précaution lors de leur fabrication.

### ARRIERE-PLAN TECHNOLOGIQUE

Les récents progrès dans le domaine de la microélectronique ont conduit au développement de systèmes d'élaboration de plaques fines voire ultra-fines dont l'épaisseur est comprise typiquement entre 20 et 200 micromètres. Plusieurs techniques ont été développées pour le traitement et la manipulation de ces plaques fines, notamment par des procédés de collage temporaire. Plus précisément, la technique de collage temporaire permet de manipuler et de réaliser des étapes technologiques sur une plaque fine supportée par une plaque dite « support » ou « poignée » par exemple en verre ou en silicium, qui demeure plus épaisse. Il s'agit de coller de façon temporaire la plaque fine sur laquelle vont être réalisées des étapes technologiques sur une plaque « support », assurant la rigidité mécanique de l'ensemble. Lorsque l'ensemble des étapes est terminé, la plaque fine va être décollée de la plaque « support ». L'amincissement, pour obtenir la plaque fine, peut également avoir lieu après collage sur un substrat support, la plaque ainsi amincie pouvant ensuite ou non subir des étapes technologiques additionnelles en vue de la réalisation de tout ou partie de composants électroniques et/ou optiques et/ou mécaniques. Dans de nombreuses techniques de collage temporaire, le décollement se fait avec un enchainement d'actions chimiques et mécaniques.

Le document US2014/0084423 décrit un procédé de collage temporaire d'une plaque amincie sur une plaque « support ». Le procédé comprend en outre une étape de détourage de la zone périphérique de la plaque amincie. Cette étape de découpe des bords de la plaque préalablement amincie alors supportée par la plaque « support » est réalisée au moyen d'une roue diamantée. Cette étape de détourage est habituellement réalisée par un moyen mécanique. Elle peut ainsi générer sur la plaque amincie des dommages a posteriori. L'étape de découpe est suivie d'une étape de désolidarisation de la plaque amincie de la plaque « support ». Cette suite d'étapes présente des limitations pour des plaques fines. En effet, dans le cas où la plaque obtenue après l'étape de désolidarisation est particulièrement fine (s'étendant d'une épaisseur inférieure à 200 micromètres, par exemple), aucune solution permettant la manipulation sans risque de casse de la plaque amincie n'est envisagée. Dans ce cas, aucun procédé n'est dès lors envisageable après la désolidarisation ; un procédé de découpe puce par puce de la plaque amincie sera par exemple irréalisable. Dans le cas où la plaque amincie obtenue après l'étape de désolidarisation présente une contrainte mécanique importante, il y a également de fortes chances que la plaque amincie subisse a posteriori une déformation en forme de tuile, ce qui rend, là encore, délicate la manipulation de la plaque amincie et très probablement fragilisée lors de la poursuite du procédé de réalisation. Ainsi, le procédé proposé dans le document US2014/0084423, de par la fragilisation de la plaque amincie qu'il entraine suite aux contraintes mécaniques effectuées sur ladite plaque, est difficilement industrialisable.

La présente invention permet de résoudre tout ou, du moins, une partie des inconvénients des techniques actuelles en proposant un procédé de réalisation alternatif et compatible avec une utilisation dans l'industrie.

### RESUME DE L'INVENTION

L'invention concerne un procédé selon la revendication 1 et un dispositif électronique selon la revendication 13. De plus, l'invention concerne un système selon la revendication 15. La présente invention propose un procédé alternatif de collage temporaire permettant de préserver au maximum le substrat ayant préalablement subi un amincissement lors du procédé de réalisation. La présente invention évite de recourir lors du procédé de réalisation à des actions mécaniques pouvant entrainer des risques de fissures voire de casse. Avantageusement, le procédé selon la présente invention est compatible avec un environnement industriel.

Suivant des aspects avantageux indicatifs, des modes de réalisation de l'invention permettent d'avoir une zone d'adhésion beaucoup plus forte avec le deuxième substrat au niveau de la zone périphérique qu'au niveau de la couche tampon, ce qui renforce l'adhésion globale des deux substrats et permet l'utilisation de matériaux de couche tampon beaucoup plus nombreux. Cela peut permettre également compte tenu de la faible adhésion possible au niveau de la couche tampon d'en faciliter l'élimination. De plus la zone périphérique délimite ainsi avec le fond de la cavité une cavité avantageusement hermétique dans laquelle se situe la couche tampon. Cette couche tampon est en général une couche de polymère, matériau très sensible à certains traitements et/ou solvants, ce qui limite les étapes technologiques réalisables si ce matériau est potentiellement accessible notamment par le flanc du substrat. Ce matériau se trouvant ici possiblement dans une cavité hermétique, il est possible de réaliser toute sorte d'étapes technologiques sur la face du substrat opposée à la face du collage qui ne seraient pas possibles si la couche tampon était accessible.

### BREVE INTRODUCTION DES FIGURES

Les buts, objets, ainsi que les caractéristiques et avantages de l'invention ressortiront mieux de la description détaillée d'un mode de réalisation de cette dernière, qui est illustré par les dessins d'accompagnement suivants, dans lesquels :
- La figure 1 illustre un substrat comprenant au moins une cavité bordée d'au moins une zone périphérique.
- Les figures 2a, 2b, 2c et 2d illustrent le substrat doté d'une cavité remplie d'une couche tampon. La figure insérée de la figure 2c représente une vue de dessus de la figure 2c.
- La figure 3 illustre une étape de positionnement relatif du substrat avec un substrat additionnel.
- La figure 4 illustre une étape d'amincissement du substrat additionnel par la face arrière.
- La figure 5 illustre une étape de réalisation d'étapes technologiques à partir de la face amincie du substrat additionnel.
- La figure 6 illustre une étape de de retrait du fond de la cavité du substrat.
- La figure 7 illustre une étape de retrait de la couche tampon.
- La figure 8 illustre une étape de mise en positionnement du substrat additionnel sur un troisième substrat.
- La figure 9 illustre une étape de retrait de la zone périphérique du premier substrat.
- La figure 10 illustre une étape de désolidarisation du substrat additionnel du troisième substrat.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- la zone périphérique est collée à la première face du deuxième substrat par collage direct.
- la zone périphérique peut être collée à la première face du deuxième substrat pour former la totalité de l'interface de collage.
- Une étape de retrait de la couche tampon est effectuée après l'étape de retrait du fond de la cavité.
- L'étape de retrait du fond de la cavité du premier substrat comprend une rectification.
- Une étape d'amincissement du deuxième substrat est effectuée à partir d'une deuxième face opposée à la première face dudit deuxième substrat.
- On forme au moins un composant sur la deuxième face du deuxième substrat après l'étape d'amincissement.
- Avant l'étape de retrait du fond de la cavité, l'épaisseur du deuxième substrat est choisie inférieure à 200 micromètres.
- Une étape de retrait de la zone périphérique est effectuée après l'étape de retrait du fond de la cavité.
- L'étape de retrait de la zone périphérique comprend une gravure.
- Une étape de solidarisation du deuxième substrat avec un troisième substrat est réalisée de sorte à ce que la deuxième face du deuxième substrat, soit positionnée en regard d'une première face du troisième substrat.
- L'étape de solidarisation est opérée après l'étape de retrait du fond de la cavité.
- Une étape de désolidarisation du deuxième substrat avec le troisième substrat est effectuée.
- L'étape de désolidarisation du deuxième substrat avec le troisième substrat comprend une étape de découpe du deuxième substrat de sorte à former, à partir du deuxième substrat, une pluralité de puces distinctes et désolidarisées entre elles.
- On dépose sur le troisième substrat une couche en matériau adhésif sur sa première face ; ladite couche formant une interface de collage permettant de solidariser le deuxième substrat et le troisième substrat.
- L'étape de retrait de la zone périphérique est opérée après l'étape de solidarisation.
- La couche tampon comprend un matériau soluble dans l'eau.
- La cavité s'étend suivant une profondeur inférieure à 500 micromètres et la zone périphérique s'étend suivant une largeur inférieure à 10 millimètres. Selon un exemple, cela correspondrait à une largeur de cavité de 180 millimètres pour un substrat de 200 millimètres de diamètre.
- Ledit deuxième substrat est aminci à partir de sa deuxième face, opposée à la première face.
- Le deuxième substrat présente une épaisseur inférieure à 200 micromètres.
- La deuxième face du deuxième substrat comprend au moins un composant.

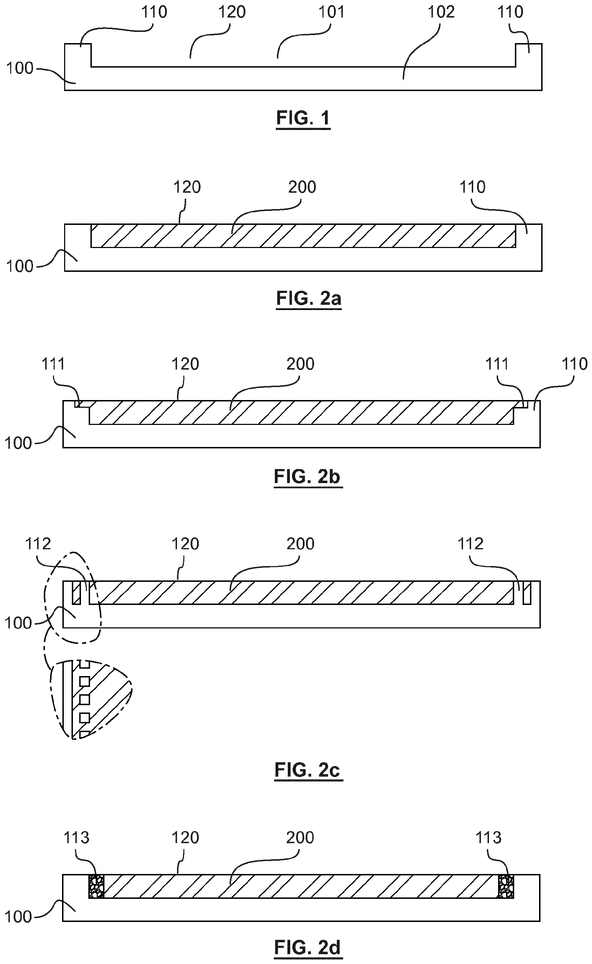

L'invention concerne la transformation de dispositifs électroniques, de préférence de dispositifs microélectroniques. Selon l'invention, on entend par dispositif microélectronique, un dispositif comportant des éléments de dimensions microniques et/ou nanométriques. Le procédé qui suit a pour but préférentiel de réaliser un dispositif (micro)électronique en référence aux figures 1 à 10. On entend préférentiellement par dispositif, une puce ou une plaque (plus communément dénommée « wafer », en anglais) comprenant au moins une puce.

La **figure 1** illustre un premier substrat 100 doté d'au moins une cavité 120 formée à partir d'une première face 101, opposée à une deuxième face 102 dudit premier substrat 100. La cavité 120 présente un fond s'étendant selon une dimension de largeur suivant un plan perpendiculaire à l'épaisseur du substrat 100 et s'étendant selon une dimension d'épaisseur suivant un plan parallèle à l'épaisseur du substrat 100 ; le fond de la cavité 120 comprenant une partie de l'épaisseur du premier substrat 100. La cavité présente une dimension de profondeur s'étendant suivant l'épaisseur du premier substrat 100. La somme de l'épaisseur du fond de la cavité 120 et la profondeur de la cavité 120 forme l'épaisseur du premier substrat 100. La cavité 120 présente, relativement à l'épaisseur du fond, une sur-épaisseur sur les bords ou zone périphérique 110. La zone périphérique présente une dimension de hauteur s'étendant suivant l'épaisseur du premier substrat 100 avantageusement égale à l'épaisseur du premier substrat 100. Selon un mode de réalisation préféré, la zone périphérique 110 se situe en bordure du substrat. La zone périphérique 110 se présente avantageusement sous la forme d'un contour fermé. La zone périphérique 110 peut être de n'importe quelle forme. Elle peut par exemple être sous forme annulaire selon un plan en coupe par rapport à l'épaisseur du substrat. La zone périphérique 110 comprend une paroi, la paroi ayant une face interne délimitant la cavité 120 et une face externe, par rapport à la cavité 120. La paroi de la zone périphérique 110 est à la fois débouchante en face avant et face arrière du substrat. La partie de la zone périphérique débouchant en face avant (première face) forme une zone, de préférence plane, qui réalise une surface du substrat en surplomb de la cavité 120. Cette zone est de préférence parallèle à une surface en correspondance de la première face du deuxième substrat. Avantageusement, le premier substrat est amené à être mis en contact avec le deuxième substrat uniquement par cette zone. Le premier substrat 100 est, de préférence, formé en un matériau à base de silicium (par exemple, en silicium poly-cristallin). Le premier substrat 100 peut également être, tout ou en partie, en poly-silicium ou bien en verre notamment. De manière particulièrement avantageuse, la présente invention s'applique à tout type de substrat. Ainsi, un substrat à base de silice, de saphir, de germanium peut être utilisé aussi bien qu'un substrat à base de métal. Le substrat peut être également multi-couches. Selon un exemple de réalisation non limitatif de l'invention, la zone périphérique 110 possède une hauteur, s'étendant suivant l'épaisseur du premier substrat 100, comprise entre 100 et 500 micromètres et une largeur, s'étendant perpendiculairement à l'épaisseur du premier substrat 100, comprise entre 2 et 10 millimètres.

Les **figures 2a, 2b, 2c** et **2d** illustrent une étape de remplissage de la cavité 120 par une couche tampon 200. La couche tampon 200 a pour fonction de venir au contact de composants et éventuellement de la face 301 du deuxième substrat 300 qui les porte et contribue à la rigidité mécanique de l'ensemble. La couche tampon 200 comprend un matériau qui peut être un polymère, un adhésif ou bien un matériau soluble dans l'eau (tel que le sel). A titre d'exemple, il peut s'agir d'un polymère de référence BSI5150 commercialisé par Brewer ou encore de référence LC5200 commercialisé par 3M. La couche tampon 200 comprend de préférence un matériau visqueux. De manière particulièrement avantageuse, la zone périphérique 110 peut comprendre des moyens sur sa paroi interne afin de permettre une dilatation du matériau formant la couche tampon 200, suite à des variations de température. Selon un mode de réalisation illustré en figure 2b, il peut s'agir notamment d'un épaulement 111 au niveau de la zone périphérique 110. Selon un autre mode de réalisation illustré en figure 2c, il peut également s'agir d'une cavité complémentaire 112 réalisée dans la zone périphérique 110 et communiquant avec la cavité 120 pour permettre de recevoir le matériau de la couche tampon 200 qui serait en excès. La cavité complémentaire peut selon un exemple se présenter sous forme de piliers 112 (vue de dessus de la figure 2c). Selon un autre exemple de réalisation illustré en figure 2d, la zone périphérique 110 peut également comprendre un matériau poreux 113, par exemple du silicium poreux. La couche tampon ne recouvre pas la surface supérieure de la zone périphérique 110 exposée au niveau de la première face 101. Par exemple, la hauteur de la couche tampon peut être inférieure ou égale à celle entre la paroi interne du fond de la cavité et la surface supérieure de la zone périphérique 110. Le matériau de la couche tampon est donc alors totalement circonscrit au volume délimité par la cavité 120.

De préférence, la cavité est unique sur le premier substrat 100 et/ou est configurée pour recevoir en regard l'ensemble de la première face du deuxième substrat hormis la partie de la première face du deuxième substrat qui est au contact de la zone périphérique 110.

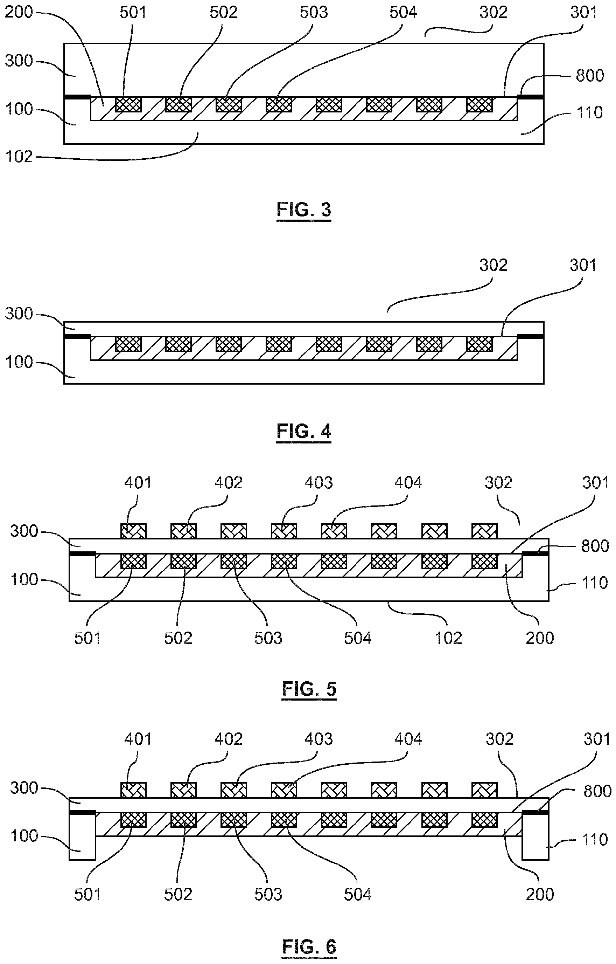

La **figure 3** illustre une étape de positionnement relatif d'un deuxième substrat 300 sur le premier substrat 100 de sorte à ce qu'une première face 301 du deuxième substrat 300 soit en regard de la cavité 120 (c'est-à-dire en regard de la première face 101) du premier substrat 100. Le deuxième substrat 300 est, de préférence, formé en un matériau à base de silicium (par exemple, en silicium poly-cristallin). Le premier substrat 100 peut également être en verre ou à base de silice, de saphir, de germanium notamment. Le deuxième substrat 300 peut être également à base de métal. Le deuxième substrat 300 peut être multi-couches. Le premier substrat 100 et le deuxième substrat 300 sont solidarisés par une interface de collage 800. Avantageusement, l'interface de collage 800 est un collage direct (sans matériau adhésif). Selon un mode de réalisation, l'interface de collage 800 est un collage métallique. Selon un autre mode de réalisation, l'interface de collage 800 comprend un adhésif de type polymère. Préalablement à l'étape de positionnement, on réalise sur la première face 301 du deuxième substrat 300 des étapes technologiques en vue de former des composants ou dispositifs fonctionnels tels que des vias, des transistors, des antennes, des systèmes microfluidiques, des microsystèmes électromécaniques (acronyme « MEMS » en anglais pour « Microelectromechanical system »); les composants comprenant par exemple un organe de connexion électrique, ou autrement dit tout type d'organe pouvant être mis en continuité électrique. Les composants peuvent par exemple comprendre une portion de via électrique. Ils sont avantageusement formés en utilisant des techniques de lithographie, de gravure, de dépôt et de traitement thermique. Sur les figures, par souci de simplification, seules les parties des dispositifs faisant saillie du substrat sont représentées et référencées 501, 502, 503, 504, Ces parties en saillie correspondent généralement à des plots de connexions (encore connus sous les termes anglais de « bumps » ou « copper pillars »), les parties actives des composants étant « enterrés » dans le substrat et non représentés sur les schémas. Ces plots de connexions peuvent être réalisés notamment à base de cuivre et/ou d'étain et/ou d'argent. De manière particulièrement avantageuse, les composants 501, 502, 503, 504 sont réalisés de sorte à présenter une dimension (en saillie par rapport à la surface) d'épaisseur s'étendant suivant l'épaisseur du premier substrat 100 inférieure à l'épaisseur de la couche tampon 200 et donc inférieure à la profondeur de la cavité 120 ; l'épaisseur de la couche tampon 200 s'étendant suivant l'épaisseur du substrat 100. Avantageusement, la couche tampon 200 est configurée pour accueillir les composants 501, 502, 503, 504.
Avantageusement, au moins une partie de la première face 301 du deuxième substrat 300 est en contact avec la couche tampon 200. De manière particulièrement avantageuse, l'énergie d'adhésion est quasiment nulle ou nulle entre le matériau de la couche tampon 200 du premier substrat 100 et la première face 301 du deuxième substrat 300. De préférence, cette énergie est strictement inférieure à celle produite au niveau de la zone périphérique. Ainsi, la solidarisation entre les premier et deuxième substrats 100, 300 est assurée essentiellement au niveau de la zone périphérique et est temporaire ; les premier et deuxième substrats 100, 300 pouvant être ultérieurement désolidarisés sans exercer des contraintes mécaniques excessives sur l'un ou l'autre des substrats 100, 300.
Selon le mode de réalisation où au moins une cavité est réalisée sur la paroi interne de la zone périphérique 110 du premier substrat 100, ladite cavité pourra avantageusement permettre au matériau de la couche tampon 200 de se réorganiser, de façon à assurer un bon contact avec la première face 301 du deuxième substrat 300, et notamment dans le cas où ledit deuxième substrat 300 présente une topographie importante. De manière particulièrement avantageuse, le contact entre le matériau de la couche tampon 200 et la première face 301 du deuxième substrat 300 assure une tenue mécanique desdits premier et deuxième substrats 100, 300.

La **figure 4** illustre une étape d'amincissement du deuxième substrat 300 à partir d'une deuxième face 302, opposée à la première face 301 dudit deuxième substrat 300. Selon un mode de réalisation, l'amincissement est réalisé par rectification, par exemple à l'aide d'une roue diamantée éventuellement complétée d'une étape de polissage mécano-chimique. Avantageusement, le premier substrat 100 associée à la couche tampon 200 sert de support mécanique au deuxième substrat 300 de sorte à ce que le deuxième substrat 300 ne subisse pas de déformation voire de fissuration lors de son amincissement. En particulier, la couche tampon 200 permet d'amortir les mouvements ou vibrations du deuxième substrat 300 en appui sur le premier substrat 100, lors de l'étape d'amincissement. De manière particulièrement avantageuse, le deuxième substrat 300 possède une épaisseur de préférence comprise entre 20 et 200 micromètres après l'étape d'amincissement, typiquement de l'ordre de 80 micromètres. La **figure 5** illustre un mode de réalisation préféré où l'on réalise, après l'étape d'amincissement de la deuxième face 302 du deuxième substrat 300, des étapes technologiques en vue de former, sur ladite deuxième face 302 du substrat 300, des composants ou des dispositifs fonctionnels 401, 402, 403, 404; lesdits composants comprenant par exemple un organe de connexion électrique, ou autrement dit tout type d'organe pouvant être mis en continuité électrique. Ils sont avantageusement formés en utilisant par exemple des techniques de lithographie, de gravure, de dépôt et de traitement thermique.

La **figure 6** illustre une étape de retrait du fond de la cavité 120 réalisée de sorte à éliminer le premier substrat 100 en deçà de la première couche 200. L'étape de retrait est réalisée de sorte à laisser en place la zone périphérique 110 du premier substrat 100. Selon un mode de réalisation, l'étape de retrait est réalisée par polissage mécano-chimique. A titre d'exemple, l'étape de retrait est réalisée au moyen d'une roue diamantée. Dans ce mode de réalisation particulier, on réduit l'épaisseur de la zone périphérique 110. Selon un autre mode de réalisation, l'étape de retrait du fond de la cavité 120 est réalisée par gravure, par exemple chimique. A titre d'exemple, une gravure chimique à base de Tetramethylammonium hydroxide (TMAH ou TMAOH) pourrait convenir pour retirer le fond de la cavité 120 du premier substrat 100 formé en un matériau à base de silicium, par exemple. Cette gravure, étant isotrope, est préférentiellement opérée après masquage de la partie de la deuxième face 102 correspondant à la zone périphérique 110. Selon un mode de réalisation préférentiel, l'étape de retrait du fond de la cavité 120 est opérée par gravure anisotrope, par exemple, au moyen d'une gravure par plasma.

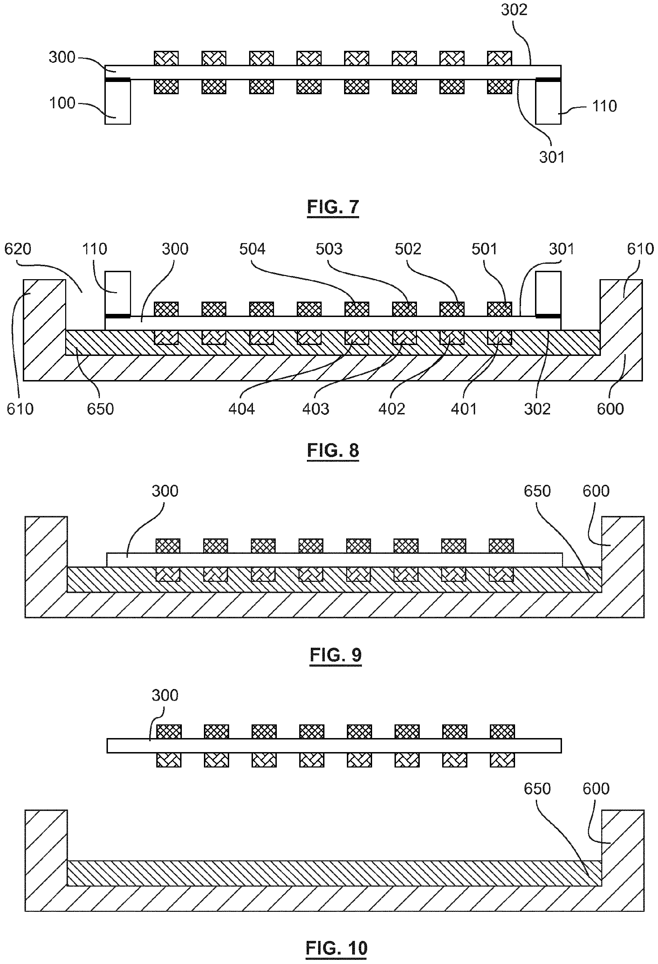

La **figure 7** illustre l'étape de retrait de la première couche 200 à partir de la deuxième face 102 du premier substrat 100. L'étape de retrait de la couche tampon 200 est réalisée de préférence par gravure. Selon un mode de réalisation, la couche tampon 200 est retirée par gravure chimique, par exemple à l'aide d'un solvant adapté ou par gravure sèche (plasma). Il est possible également de réaliser un pelage mécanique de la couche tampon 200. Dans ce cas, on vient par exemple laminer un film adhésif sur la couche tampon 200, ce film présentant une énergie d'adhésion avec la couche tampon 200 supérieure à l'énergie d'adhésion entre la couche tampon et la première face 101 du substrat 300. On vient ensuite peler le film adhésif qui entraine avec lui la couche tampon 200. De manière particulièrement avantageuse, l'étape de retrait de la couche tampon 200 est facilitée, grâce à la faible adhésion existant entre le matériau de la couche tampon 200 et la première face 301 du deuxième substrat 300.

La **figure 8** illustre l'étape de solidarisation du deuxième substrat 300 sur un troisième substrat 600 de sorte à ce que la deuxième face 302 du deuxième substrat 300 soit en regard d'une première face du troisième substrat 600. Le troisième substrat 600 est, de préférence, formé en un matériau à base de silicium (par exemple, en silicium poly-cristallin). Le troisième substrat 600 peut également être, tout ou en partie, en poly-silicium ou bien en verre. De manière particulièrement avantageuse, la présente invention s'applique à tout type de substrat. Ainsi, un troisième substrat 600 à base de silice, de saphir, de germanium peut être utilisé aussi bien qu'un substrat à base de métal. Le troisième substrat 600 peut être multi-couches. Avantageusement, le troisième substrat 600 comprend au moins une cavité 620 réalisée à partir de la première face du troisième substrat 600. La cavité 620 du troisième substrat présente une sur-épaisseur sur les bords ou zone périphérique 610. Le troisième substrat 600 comprend de préférence une couche 650 adhésive formée sur un cadre de découpe. Selon un exemple de réalisation, la couche 650 adhésive comprend un adhésif thermo-conducteur ou un adhésif activable par rayons ultra-violets. De manière particulièrement avantageuse, les composants 401, 402, 403, 404 sont réalisés de sorte à présenter une dimension d'épaisseur, s'étendant suivant l'épaisseur du premier substrat 100, inférieure à l'épaisseur de la couche 650 adhésive soit inférieure à la profondeur de la cavité 620. Avantageusement, la couche 650 adhésive est configurée pour accueillir les composants 401, 402, 403, 404 formés sur le deuxième substrat 300, et éventuellement venir au contact de la deuxième face 302. Selon un exemple de réalisation non limitatif de l'invention, la zone périphérique 610 possède une profondeur s'étendant suivant l'épaisseur du troisième substrat 600 comprise entre 100 et 500 micromètres et une largeur s'étendant perpendiculairement à l'épaisseur du premier substrat 100 comprise entre 2 et 10 millimètres. De manière particulièrement avantageuse, la zone périphérique 610 permet de rigidifier l'ensemble comprenant le troisième substrat 600 solidaire du deuxième substrat 300. L'étape de solidarisation du deuxième substrat 300 sur le troisième substrat 600 est facilitée par la rigidité du troisième substrat 600 qui supporte avantageusement le deuxième substrat 300 ; ledit deuxième substrat 300 ayant préalablement subi un amincissement.
La zone périphérique 110 est de préférence laissée en place pour l'étape de solidarisation et constituant une poignée aidant à la manipulation du deuxième substrat 300. Le fait que la zone périphérique soit collée au deuxième substrat permet qu'après élimination de la couche tampon, au moins une partie de cette zone périphérique demeure au contact du deuxième substrat participant à la rigidité de la structure obtenue et à sa manipulation.

En variante, on dispose un anneau périphérique rigide (correspondant à 610 uniquement), par exemple métallique ou plastique, autour du substrat 300 et on lamine sur l'ensemble, du côté de la face 302 du substrat 300, une bicouche composée d'un film par exemple plastique (correspondant au fond de la cavité) et d'une colle ou polymère (correspondant à 650). Cette bicouche peut être par exemple la bicouche référencée SP-537T-230 commercialisée par Furukawa. Le laminateur utilisé peut être le laminateur référencé 850 commercialisé par EVG.

La **figure 9** illustre une étape de retrait de la zone périphérique 110 solidarisée au deuxième substrat 300. Le deuxième substrat 300 aminci acquiert une rigidité de par sa solidarisation avec le troisième substrat 600. La zone périphérique 110 du premier substrat 100 fixée sur le deuxième substrat peut ainsi être retirée sans provoquer de dommage pour le deuxième substrat 300. Le retrait de la zone périphérique 110 peut être réalisé par gravure chimique ou mécano-chimique par meulage à l'aide d'une scie diamantée, par exemple. Selon un mode de réalisation, la zone périphérique 110 peut être enlevée avant le retrait de couche tampon 200. Dans ce cas, la couche tampon 200 peut servir de protection en cas de gravure chimique.

La **figure 10** illustre une étape de désolidarisation du deuxième substrat 300 et du troisième substrat 600. L'étape de désolidarisation est facilitée grâce à la faible adhésion entre les deuxième et troisième substrats mis en regard. L'étape de désolidarisation est réalisée par exemple par attaque chimique de la couche 650 adhésive. En variante, dans le cas d'une bicouche film plastique/colle, il est possible également d'insoler la couche 650 au travers du film plastique à l'aide d'un rayonnement ultra-violet par exemple. Ce rayonnement entraine une réticulation de la colle qui se rétracte et se désolidarise ainsi complètement de la deuxième face 302 du substrat 300 entrainant la désolidarisation du deuxième substrat 300 et du troisième substrat 600.

Un exemple de réalisation non limitatif qui peut être utilisé pour mieux comprendre l'invention est présenté ci-après. Cet exemple représente un cas pratique, le choix des matériaux et les dimensions sont donnés à titre indicatif et préférentiel et ne sont aucunement limitatifs de la présente invention. A partir d'une plaque de 300 millimètres de diamètre pour un premier substrat 100, on réalise un amincissement préférentiellement au moyen d'une roue diamantée d'un premier substrat 100 en silicium. Une cavité 120 est formée sur ledit premier substrat 100 dotée d'une zone périphérique 110. La profondeur de la cavité 120 s'étendant selon l'épaisseur du premier substrat 100 est de préférence de l'ordre de 300 micromètres et la largeur de la cavité 120 s'étendant perpendiculairement à l'épaisseur du premier substrat 100 est de préférence de l'ordre de 3 millimètres. La cavité 120 du premier substrat 100 est remplie d'une couche tampon 200, par exemple, au moyen d'une résine réticulée sous ultra-violets. L'épaisseur de la couche tampon 200 est de préférence de l'ordre de 300 micromètres. Préalablement à une étape de positionnement relatif d'un deuxième substrat 300 sur le premier substrat 100, on forme de préférence une interface de collage 800 sur la face supérieure de la zone périphérique 110. Avantageusement, l'interface de collage 800 se présente sous la forme d'une couche adhésive. Le deuxième substrat 300 est choisi de préférence à base de silicium. On forme sur une première face 301 du deuxième substrat 300, une couche supérieure, de préférence à base de nitrure de silicium, d'une épaisseur approximant les 100 nanomètres. Avantageusement, le deuxième substrat 300 est ensuite reporté sur le premier substrat 100 de sorte à ce que la première face 301 du deuxième substrat 300 soit positionnée en regard de la cavité 120 du premier substrat 100. Les premier et deuxième substrats 100, 300 sont solidarisés entre eux au moyen de l'interface de collage 800. Cette étape de collage est réalisée à une température préférentielle avoisinant les 180°C afin de favoriser les phénomènes d'adhésion entre les premières faces 101, 301 des deux substrats 100, 300 en regard.
Avantageusement, le deuxième substrat 300 subit un amincissement à partir de sa deuxième face 302, opposée à la première face 301. L'amincissement est par exemple réalisé par polissage au moyen d'une roue diamantée. L'amincissement est avantageusement réalisé jusqu'à obtenir une épaisseur du deuxième substrat 300 de l'ordre de 80 micromètres. Après l'étape d'amincissement à partir de la deuxième face 301 du deuxième substrat 300, on forme une couche additionnelle, de préférence à base de dioxyde de silicium, sur ladite deuxième face 301 du deuxième substrat 300. Cette couche additionnelle est réalisée à une température de 150°C et possède une épaisseur par exemple de l'ordre de 1 micromètres. On procède ensuite au retrait partiel du fond de la cavité 120 du premier substrat 100 de sorte à atteindre la première couche 200 à partir de la deuxième face 102 du premier substrat 100. Le retrait du fond de la cavité 120 est par exemple réalisé par amincissement au moyen d'une roue diamantée.
Préférentiellement, on procède ensuite au retrait de la première couche 200 de sorte à atteindre la première face 301 du deuxième substrat 300. Le retrait est réalisé par exemple par pelage mécanique au moyen d'une bande adhésive. De préférence, le deuxième substrat 300 est positionné relativement à un troisième substrat 600. Le troisième substrat comprend une couche 650 adhésive préalablement formée sur un cadre d'une épaisseur préférentielle de 450 millimètres. Une étape de découpe de puces de préférence au moyen d'une scie diamantée est réalisée. Préférentiellement, les puces sont séparées de la couche adhésive par insolation à l'aide de rayons ultra-violets, entrainant la réticulation de la couche adhésive.

De manière particulièrement avantageuse, l'ordre de réalisation des étapes de séparation n'a pas d'importance et dépend des applications. Avantageusement, le retrait de la couche tampon 200 peut être effectué, selon un premier mode de réalisation, avant l'étape de solidarisation du deuxième substrat 300 sur le troisième substrat 600 comprenant la couche 650 adhésive et le cadre. Selon un deuxième mode de réalisation, la couche tampon 200 peut être retirée après l'étape de solidarisation du deuxième substrat 300 sur ledit troisième substrat 600 ou après le retrait de la zone périphérique 110 du premier substrat 100.

Il est possible selon le procédé de la présente invention de renouveler l'étape de positionnement du deuxième substrat 300 sur un nouveau substrat « support » afin de réaliser de nouvelles étapes technologiques sur la première face 301 après élimination de la première couche 200. Pour cela, on procède à une étape de solidarisation du deuxième substrat 300 sur un nouveau substrat comprenant un matériau tampon. Ce nouvel ensemble (deuxième substrat supporté par un substrat additionnel faisant office de support) sera démonté en fin de procédé avant le collage sur le nouveau substrat support. Le détourage ou retrait de la zone périphérique 110 du premier substrat 100 supporté par le troisième substrat 600 n'est pas toujours nécessaire, on peut en effet réaliser une découpe des puces en présence de la zone périphérique 610.

Le procédé selon la présente invention permet de former un dispositif électronique dont l'épaisseur est amoindrie (de l'ordre de 20 micromètres) parfaitement supporté par un troisième substrat 600 comprenant une couche adhésive sur une première face déposée sur un cadre. Ceci empêche avantageusement l'apparition de fissures sur le dispositif électronique. Préalablement à la désolidarisation du deuxième substrat 300 et du troisième substrat 600, le deuxième substrat 300 peut avantageusement subir des étapes de découpes supplémentaires, par exemple au moyen d'une scie diamantée, de façon à libérer les puces présentes sur ledit deuxième substrat 300.

La présente invention permet de manière particulièrement avantageuse dans le cas où le deuxième substrat 300 obtenu après la séparation est particulièrement fin (s'entendant d'une épaisseur inférieure à 200 micromètres) ou s'il présente une contrainte mécanique importante, la fixation sur la couche 650 adhésive associé au cadre permet une manipulation aisée et sans risque de fissuration.
D'autre part, le procédé de désolidarisation des puces par découpe du deuxième substrat 300 est facilité via l'utilisation du troisième substrat 600 comprenant la couche 650 adhésive et le cadre.

De manière particulièrement avantageuse, le procédé selon la présente invention est compatible avec un environnement industriel. Le système est compatible avec des procédés dont la température approxime le 250°C en cas de collage adhésif au niveau de l'interface 800 et jusque 400°C voire au-delà en cas de collage direct, par exemple métallique. Lors de l'étape de collage de la première face 301 du deuxième substrat 300 sur la première face 101 du premier substrat 100, notamment dans le cas où la première face 301 du deuxième substrat 300 présente une topographie importante, les trous aménagés sur la paroi interne de la zone périphérique 110 du premier substrat 100 assurent un bon contact entre le matériau de la couche tampon 200 et le deuxième substrat 300. Les trous permettent également une bonne dilatation thermique du matériau si nécessaire.

De manière particulièrement avantageuse, le procédé selon la présente invention permet de s'affranchir d'une étape de détourage complexe réalisée sur un substrat aminci ; ladite étape pouvant endommager ledit substrat aminci.

La présente invention n'est pas limitée aux modes de réalisation précédemment décrits mais s'étend à tout mode de réalisation conforme aux revendications.

## Revendications

1. Procédé de transformation d'un dispositif électronique à partir d'un état initial dans lequel le dispositif comprend un premier substrat (100) et un deuxième substrat (300), lesdits premier et deuxième substrats (100, 300) étant solidarisés au moyen d'une interface de collage (800) à partir de leurs premières faces (101, 301) respectives, état initial dans lequel le premier substrat (100) comprend au moins une cavité (120), réalisée à partir de la première face (101) du premier substrat (100), ladite cavité (120) comportant un fond bordé d'au moins une zone périphérique (110) et étant remplie au moins partiellement d'une couche tampon (200), et dans lequel la première face (301) du deuxième substrat (300) est au moins en partie en regard de la cavité (120) du premier substrat (100), la zone périphérique (110) étant collée à la première face (301) du deuxième substrat (300), sans présence du matériau de la couche tampon (200) à leur interface, pour former au moins une partie de l'interface de collage (800), le deuxième substrat (300) comprenant au moins un composant (501, 502, 503, 504) dont une partie est en saillie sur la première face (301) dudit deuxième substrat (300), la couche tampon (200) étant formée pour venir au contact de la partie en saillie dudit au moins un composant (501, 502, 503, 504),
procédé qui comprend une étape de retrait du fond de la cavité (120) du premier substrat (100) à partir d'une deuxième face (102), opposée à la première face (101) du premier substrat (100), l'étape de retrait du fond de la cavité (120) étant configurée pour rendre la cavité débouchante et préserver au moins en partie la zone périphérique (110).

2. Procédé selon la revendication précédente, comprenant une étape de retrait de la couche tampon (200) après l'étape de retrait du fond de la cavité (120).

3. Procédé selon l'une des revendications précédentes, dans lequel la zone périphérique (110) est collée à la première face (301) du deuxième substrat (300) par collage direct, par un collage métallique ou à base de nitrure de silicium ou par un adhésif polymère.

4. Procédé selon l'une des revendications précédentes, dans lequel la zone périphérique (110) est collée à la première face (301) du deuxième substrat (300) pour former la totalité de l'interface de collage (800).

5. Procédé selon l'une quelconque des revendications précédentes comprenant une étape d'amincissement du deuxième substrat (300) à partir d'une deuxième face (302) opposée à la première face (301) dudit deuxième substrat (300).

6. Procédé selon la revendication précédente dans lequel on forme au moins un composant (401, 402, 403, 404) sur la deuxième face (302) du deuxième substrat (300) après l'étape d'amincissement.

7. Procédé selon l'une quelconque des revendications précédentes comprenant une étape de retrait de la zone périphérique (110), après l'étape de retrait du fond de la cavité (120).

8. Procédé selon l'une quelconque des revendications précédentes comprenant une étape de solidarisation du deuxième substrat (300) avec un troisième substrat (600), réalisée de sorte à ce que la deuxième face (302) du deuxième substrat (300), soit positionnée en regard d'une première face du troisième substrat (600).

9. Procédé selon la revendication précédente dans lequel l'étape de solidarisation est opérée après l'étape de retrait du fond de la cavité (120).

10. Procédé selon la revendication 8 ou 9 comprenant une étape de désolidarisation du deuxième substrat (300) avec le troisième substrat (600).

11. Procédé selon la revendication précédente dans lequel l'étape de désolidarisation du deuxième substrat (300) avec le troisième substrat (600) est précédée d'une étape de découpe du deuxième substrat (300) de sorte à former, à partir du deuxième substrat (300), une pluralité de puces distinctes et désolidarisées entre elles.

12. Procédé selon l'une quelconque des deux revendications précédentes dans lequel on dépose sur le troisième substrat (600) une couche (650) en matériau adhésif sur sa première face ; ladite couche (650) formant une interface de collage permettant de solidariser le deuxième substrat (300) et le troisième substrat (600).

13. Dispositif électronique comprenant un premier substrat (100) et un deuxième substrat (300), lesdits premier et deuxième substrats (100, 300) étant solidarisés au moyen d'une interface de collage (800) à partir de leurs premières faces (101, 301) respectives, dans lequel le premier substrat (100) comprend au moins une cavité (120), réalisée à partir de la première face (101) du premier substrat (100), ladite cavité (120) étant remplie au moins partiellement d'une couche tampon (200) et étant bordée d'au moins une zone périphérique (110) et dans lequel la première face (301) du deuxième substrat (300) est au moins en partie en regard de la cavité (120) du premier substrat (100), la zone périphérique (110) étant collée à la première face (301) du deuxième substrat (300), sans présence du matériau de la couche tampon (200) à leur interface, pour former au moins une partie de l'interface de collage (800), dispositif dans lequel la cavité (120) est sans fond, la couche tampon étant ainsi à découvert, et dans lequel le deuxième substrat (300) comprend au moins un composant (501, 502, 503, 504) dont une partie est en saillie sur la première face (301) dudit deuxième substrat (300), la couche tampon (200) étant configurée pour venir au contact de la partie en saillie dudit au moins un composant (501, 502, 503, 504).

14. Dispositif selon la revendication précédente dans lequel la deuxième face (302) du deuxième substrat (300), comprend au moins un composant (401, 402, 403, 404, 501, 502, 503, 504).

15. Système comprenant le dispositif selon l'une quelconque des revendications 13 à 14 et comprenant un troisième substrat (600) ; le dispositif étant assemblé par la deuxième face (302) du deuxième substrat 300) du dispositif, qui est opposée à la première face (301) du deuxième substrat (300) du dispositif, à une face du troisième substrat (600).

## Patentansprüche

1. Umwandlungsverfahren einer elektronischen Vorrichtung aus einem Anfangszustand, in dem die Vorrichtung ein erstes Substrat (100) und ein zweites Substrat (300) umfasst, wobei das erste und das zweite Substrat (100, 300) jeweils von ihren ersten Seiten (101, 301) aus mittels einer Bondingschnittstelle (800) verbunden sind, wobei in dem Anfangszustand das erste Substrat (100) mindestens einen Hohlraum (120) umfasst, der ausgehend von der ersten Seite (101) des ersten Substrats (100) ausgebildet wird, wobei der Hohlraum (120) einen Boden umfasst, der zumindest durch eine Randzone (110) umgeben ist, und zumindest teilweise mit einer Pufferschicht (200) aufgefüllt ist, und in dem die erste Seite (301) des zweiten Substrats (300) zumindest teilweise dem Hohlraum (120) des ersten Substrats (100) zugewandt ist, wobei die Randzone (110) an die erste Seite (301) des zweiten Substrats (300) gebondet ist, ohne dass an deren Schnittstelle Material der Pufferschicht (200) vorhanden ist, um zumindest einen Teil der Bondingschnittstelle (800) zu bilden, das zweite Substrat (300) zumindest eine Komponente (501, 502, 503, 504) enthält, von der ein Teil von der ersten Seite (301) des zweiten Substrats (300) hervorsteht, die Pufferschicht (200) so ausgebildet ist, dass sie mit dem hervorstehenden Teil der zumindest einen Komponente (501, 502, 503, 504) in Kontakt kommt,
wobei das Verfahren einen Schritt des Entfernens des Bodens des Hohlraums (120) des ersten Substrats (100) ausgehend von einer zweiten Seite (102) umfasst, die der ersten Seite (101) des ersten Substrats (100) gegenüberliegt, wobei der Schritt des Entfernens des Bodens des Hohlraums (120) dazu ausgelegt ist, den Hohlraum zu öffnen und zumindest teilweise die Randzone (110) zu erhalten.

2. Verfahren nach dem vorangehenden Anspruch, umfassend einen Schritt des Entfernens der Pufferschicht (200) nach dem Schritt des Entfernens des Bodens des Hohlraums (120).

3. Verfahren nach einem der vorangehenden Ansprüche, bei dem die Randzone (110) an die erste Seite (301) des zweiten Substrats (300) durch direktes Bonden, durch Metallbonden oder auf Basis von Siliziumnitrid oder durch einen Polymerklebstoff gebondet ist.

4. Verfahren nach einem der vorangehenden Ansprüche, bei dem die Randzone (110) an die erste Fläche (301) des zweiten Substrats (300) zum Ausbilden der gesamten Bondingschnittstelle (800) gebondet ist.

5. Verfahren nach einem der vorangehenden Ansprüche, umfassend einen Schritt des Verdünnens des zweiten Substrats (300) ausgehend von einer zweiten Seite (302), die der ersten Seite (301) des zweiten Substrats (300) gegenüberliegt.

6. Verfahren nach dem vorangehenden Anspruch, bei dem zumindest eine Komponente (401, 402, 403,404) auf der zweiten Seite (302) des zweiten Substrats (300) nach dem Schritt des Verdünnens gebildet wird.

7. Verfahren nach einem der vorangehenden Ansprüche, umfassend einen Schritt des Entfernens der Randzone (110) nach dem Schritt des Entfernens des Bodens des Hohlraums (120).

8. Verfahren nach einem der vorangehenden Ansprüche, umfassend einen Schritt des Verbindens des zweiten Substrats (300) mit einem dritten Substrat (600), der so durchgeführt wird, dass die zweite Seite (302) des zweiten Substrats (300) einer ersten Seite des dritten Substrats (600) zugewandt positioniert ist.

9. Verfahren nach dem vorangehenden Anspruch, bei dem der Schritt des Verbindens nach dem Schritt des Entfernens des Bodens des Hohlraums (120) erfolgt.

10. Verfahren nach Anspruch 8 oder 9 umfassend einen Schritt des Trennens des zweiten Substrats (300) von dem dritten Substrat (600).

11. Verfahren nach dem vorangehenden Anspruch, bei dem dem Schritt des Trennens des zweiten Substrats (300) von dem dritten Substrat (600) ein Schritt des Zerschneidens des zweiten Substrats (300) vorangeht, so dass aus dem zweiten Substrat (300) mehrere einzelne, nicht miteinander verbundene Chips gebildet werden.

12. Verfahren nach einem der beiden vorangehenden Ansprüche, bei dem auf dem dritten Substrat (600) eine Schicht (650) aus Klebstoff auf seiner ersten Seite aufgebracht wird; die Schicht (650) bildet dabei eine Bondingschnittstelle, die eine feste Verbindung zwischen dem zweiten Substrat (300) und dem dritten Substrat (600) ermöglicht.

13. Elektronische Vorrichtung, umfassend ein erstes Substrat (100) und ein zweites Substrat (300), wobei das erste und das zweite Substrat (100, 300) jeweils von ihren ersten Seiten (101, 301) aus mittels einer Bondingschnittstelle (800) verbunden sind, wobei das erste Substrat (100) mindestens einen Hohlraum (120) umfasst, der ausgehend von der ersten Seite (101) des ersten Substrats (100) ausgebildet wird, wobei der Hohlraum (120) zumindest teilweise mit einer Pufferschicht (200) aufgefüllt ist und zumindest durch eine Randzone (110) umgeben ist und in dem die erste Seite (301) des zweiten Substrats (300) zumindest teilweise dem Hohlraum (120) des ersten Substrats (100) zugewandt ist, wobei die Randzone (110) an die erste Seite (301) des zweiten Substrats (300) gebondet ist, ohne dass an deren Schnittstelle Material der Pufferschicht (200) vorhanden ist, um zumindest einen Teil der Bondingschnittstelle (800) zu bilden, wobei es sich um eine Vorrichtung handelt, bei der der Hohlraum (120) keinen Boden aufweist, so dass die Pufferschicht unbedeckt ist, und bei der das zweite Substrat (300) zumindest eine Komponente (501, 502, 503, 504) enthält, von der ein Teil von der ersten Seite (301) des zweiten Substrats (300) hervorsteht, wobei die Pufferschicht (200) so ausgebildet ist, dass sie mit dem hervorstehenden Teil der zumindest einen Komponente (501, 502, 503, 504) in Kontakt kommt.

14. Vorrichtung nach dem vorangehenden Anspruch, bei der die zweite Seite (302) des zweiten Substrats (300), zumindest eine Komponente (401, 402, 403, 404, 501, 502, 503, 504) umfasst.

15. System, umfassend die Vorrichtung nach einem der Ansprüche 13 bis 14 und umfassend ein drittes Substrat (600); hierbei ist die Vorrichtung über die zweite Seite (302) des zweiten Substrats (300) der Vorrichtung, die der ersten Seite (301) des zweiten Substrats (300) der Vorrichtung gegenüberliegt, mit einer Seite des dritten Substrats (600) verbunden.

## Claims

1. Method for transforming an electronic device from an initial state wherein the device comprises a first substrate (100) and a second substrate (300), said first and second substrates (100, 300) being joined by means of a bonding interface (800) from their respective first faces (101, 301), an initial state wherein the first substrate (100) comprises at least one cavity (120), produced using the first face (101) of the first substrate (100), said cavity (120) comprising a bottom bordered by at least one peripheral region (110) and being at least partially filled with a buffer layer (200), and wherein the first face (301) of the second substrate (300) is at least partly facing the cavity (120) of the first substrate (100), the peripheral region (110) being bonded to the first face (301) of the second substrate (300), without the presence of a material of the buffer layer (200) at their interface, in order to form at least part of the bonding interface (800), the second substrate (300) comprising at least one component (501, 502, 503, 504) a portion thereof is in projection on the first face (301) of said second substrate (300), the buffer layer (200) being formed so as to contact the portion in projection of said at least one component (501, 502, 503, 504)
method that comprises a step of removing the bottom of the cavity (120) of the first substrate (100) as from a second face (102), opposite to the first face (101) of the first substrate (100), the step of removing the bottom of the cavity (120) being configured so as to let the cavity emerge while preserving at least partly the peripheral region (110).

2. A method according to the preceding claim, comprising a step of removing the buffer layer (200) after the step of removing the bottom of the cavity (120).

3. A method according to one of the preceding claims, wherein the peripheral region (110) is bonded to the first face (301) of the second substrate (300) by direct bonding, by metallic bonding or bonding based on silicon nitride or by a polymer adhesive.

4. A method according to one of the preceding claims, wherein the peripheral region (110) is bonded to the first face (301) of the second substrate (300) in order to form the entire bonding interface (800).

5. A method according to any one of the preceding claims, comprising a step of thinning the second substrate (300) from a second face (302) opposite to the first face (301) of said second substrate (300).

6. A method according to the preceding claim, wherein at least one component (401, 402, 403, 404) is formed on the second face (302) of the second substrate (300) after the thinning step.

7. A method according to any one of the preceding claims, comprising a step of removing the peripheral region (110), after the step of removing the bottom of the cavity (120).

8. A method according to any one of the preceding claims, comprising a step of joining the second substrate (300) to a third substrate (600), performed so that the second face (302) of the second substrate (300) is positioned facing a first face of the third substrate (600).

9. A method according to the preceding claim, wherein the joining step is performed after the step of removing the bottom of the cavity (120).

10. A method according to claim 8 or 9, comprising a step of disjoining the second substrate (300) from the third substrate (600).

11. A method according to the preceding claim, wherein the step of disjoining the second substrate (300) from the third substrate (600) is preceded by a step of cutting the second substrate (300) so as to form, from the second substrate (300), a plurality of separate chips disjoined from one another.

12. A method according to either one of the preceding two claims, wherein a layer (650) of adhesive material on its first face is deposited on the third substrate (600); said layer (650) forming a bonding interface making it possible to join the second substrate (300) and the third substrate (600).

13. An electronic device comprising a first substrate (100) and a second substrate (300), said first and second substrates (100, 300) being joined by means of a bonding interface (800) from their respective first faces (101, 301), wherein the first substrate (100) comprises at least one cavity (120), produced using the first face (101) of the first substrate (100), said cavity (120) being filled at least partially with a buffer layer (200), being bordered by at least one peripheral region (110), and wherein the first face (301) of the second substrate (300) is at least partly facing the cavity (120) of the first substrate (100), the peripheral region (110) being bonded to the first face (301) of the second substrate (300), without the presence of the material of the buffer layer (200) at their interface, in order to form at least part of the bonding interface (800), a device wherein the cavity (120) is bottomless the buffer layer being thus exposed wherein the second substrate (300) comprise at least one component (501, 502, 503, 504) a portion thereof is in projection on the first face (301) of the second substrate (300), the buffer layer (200) being configured so as to contact the portion in projection of said at least one component (501, 502, 503, 504).

14. A device according to the preceding claim, wherein the second face (302) of the second substrate (300) comprises at least one component (401, 402, 403, 404, 501, 502, 503, 504).

15. A system comprising the device according to any one of claims 13 to 14 and comprising a third substrate (600); the device being joined by a second face (302) of the device, which is opposite to the first face (301) of the second substrate (300) of the device, to a face of the third substrate (600).
